# EUROPÄISCHE PATENTSCHRIFT

(11) **EP 0 794 094 B1**
(45) Veröffentlichungstag und Bekanntmachung des Hinweises auf die Patenterteilung: **18.07.2001**
(21) Anmeldenummer: 97103404.6
(22) Anmeldetag: 01.03.1997
(51) Int. Cl.: B60R 21/32, H03K 5/1254, H03K 17/16

(54) **Auslöseschaltkreis, insbesondere für ein sicherheitskritisches Insassenschutzsystem für Fahrzeuge zur Personenbeförderung**
Releasing circuit in particular for a safety critical occupant protection system for vehicles transporting people
Circuit de déclenchement, notamment pour système de protection des occupants, à sécurité critique pour véhicules de transport de personnes

(30) Priorität: 05.03.1996 DE 19608393
(43) Veröffentlichungstag der Anmeldung: 10.09.1997
(73) Patentinhaber: TEMIC TELEFUNKEN microelectronic GmbH, 90411 Nürnberg (DE)
(72) Erfinder: Fendt, Günter, 86529 Schrobenhausen (DE); Hora, Peter, 86529 Schrobenhausen (DE)
(74) Vertreter: Maute, Hans-Jürgen, Dipl.-Ing.

(56) Entgegenhaltungen:
- WO-A-90/02674
- DE-A- 4 210 861
- DE-A- 4 306 488
- DE-A- 4 432 444
- DE-A- 19 514 732

## Beschreibung

Die Erfindung betrifft einen Auslöseschaltkreis, insbesondere für sicherheitskritische Insassenschutzsysteme für Fahrzeuge zur Personenbeförderung, nach dem Oberbegriff des Anspruchs 1.

Bei sicherheitskritischen Systemen, insbesondere bei sicherheitskritischen Insassenschutzsystemen, die in Fahrzeugen zur Personenbeförderung eingesetzt werden, wie z.B. Airbag-Systeme oder Gurtstraffer, wird eine hohe Systemzuverlässigkeit verlangt.

Airbag-Systeme weisen üblicherweise für jeden Airbag einen Auslöseschaltkreis mit einer den Airbag betätigenden Auslöseeinrichtung, der sog. Zündpille, auf, die in Reihe zwischen zwei Schaltern liegt. Ein mit Beschleunigungsaufnehmern zusammenwirkendes Steuergerät aktiviert im Falle eines gefährlichen Aufpralls die Auslöseeinrichtung, in dem es die im Auslöseschaltkreis befindlichen Schalter mittels eines Auslösesignals schließt. Um eine Fehlauslösung des Airbags infolge eines Fehlers im Steuergerät oder in den Beschleunigungsaufnehmern zu verhindern, ist es bekannt einen mechanischen Sicherheitsschalter im Auslöseschaltkreis vorzusehen, der auf Beschleunigungen anspricht und der den gesamten Auslösestrom schalten muß.

Da derartige Sicherheitsschalter den gesamten Auslösestrom, also beispielsweise den durch eine Zündpille fließenden Zündstrom schalten müssen, sind sie von der Kontaktauslegung her aufwendig und teuer.

Bei einem bekannten Airbag-System (Kraftfahrtechnisches Taschenbuch/Bosch, 21. Auflage, Düsseldorf, VDE Verlag, 1991, Seiten 718 ff) ist ein zentral im Fahrzeug eingebautes elektronisches Auslösegerät mit einem elektronischen Beschleunigungsaufnehmer vorgesehen, das die bei einem Aufprall entstehende Beschleunigung mißt. Um im Bedarfsfall die rechtzeitige Auslösung des Airbags und gegebenenfalls anderer personenschützender Einrichtungen zu bewirken, sind Auslöseeinrichtungen an Endstufen des Steuergeräts angeschlossen, denen ein mechanischer Sicherheitsschalter zugeordnet ist. Der mechanische Sicherheitsschalter soll eine Fehlauslösung der Airbags infolge eines Fehlers in der Elektronik ausschließen.

Es wurde auch bereits versucht, mechanische Sicherheitsschalter nur als Triggerschalter zu realisieren, so daß eine Auslösung nur dann möglich ist, wenn der Triggerschalter mechanisch beaufschlagt wird. Ein derartiger Triggerschalter kann einerseits so eingesetzt werden, daß sein Schaltungszustand von einem Mikroprozessor des Steuergeräts abgefragt und mit dem Ergebnis der Beschleunigungsmessung vom Mikroprozessor logisch verknüpft wird. Daneben ist es auch möglich, den Triggerschalter als quasi aktives Element im Auslöseschaltkreis vorzusehen, wobei die logische Verknüpfung des Auslösesignals vom Steuergerät mit dem Schaltzustand des Triggerschalters durch eine entsprechende Schaltung realisiert wird.

Die Verwendung eines mechanischen Triggerschalters als Sicherheitsschalter hat zwar den Vorteil, daß der Triggerschalter nicht den gesamten Auslösestrom schalten muß, jedoch ist es bei einem Triggerschalter ebenso wie bei einem den gesamten Auslösestrom schaltenden Sicherheitsschalter nachteilig, daß ein Prellen auftreten kann, wodurch die Auslösung der personenschützenden Mittel, also der Airbags oder der Gurtstraffer verzögert werden kann.

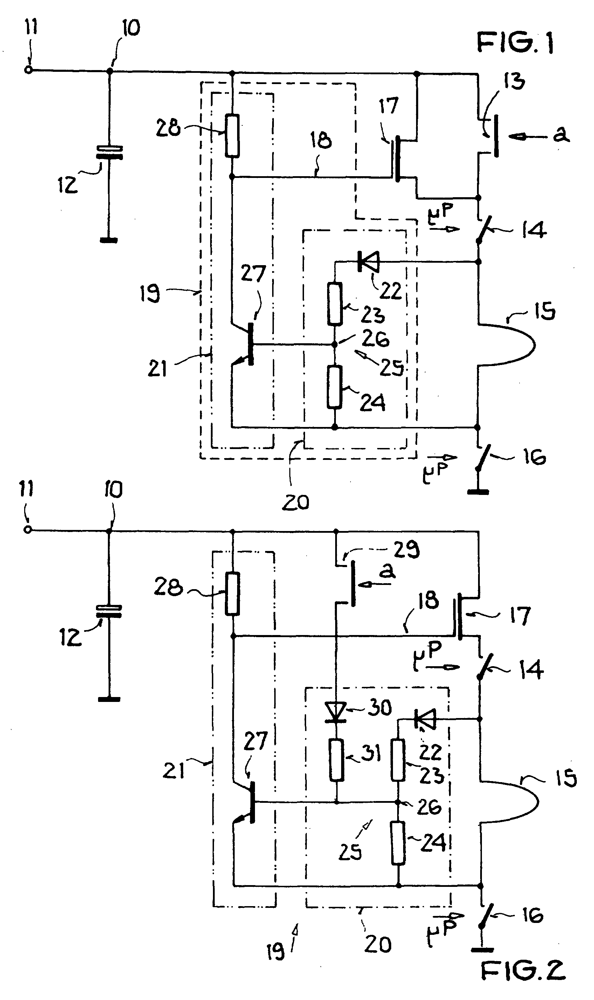

Aus diesem Grund schlägt man in der DE 43 06 488 A1 bereits einen Auslöseschaltkreis der gattungsbildenden Art vor, bei dem eine Ansteuerschaltung (dort in Fig. 1 als ASIC bezeichnet) vorgesehen ist, deren Ausgangssignal einen im Auslösestromweg angeordneten steuerbaren Schalter (Bypass-Schalter T1) in Abhängigkeit von den Schaltzuständen des Sicherheitsschalters (SI) in seinen leitenden Zustand steuert und den leitenden steuerbaren Schalter (T1) im leitenden Zustand hält. Die eigentlichen Auslöseschalter (dort T2,T3,T4) werden durch die Ansteuerschaltung nicht überwacht. Vielmehr wird eine Beeinflussung durch die Schaltzustände der anderen Schalter durch eine Diode (D1) gezielt unterdrückt.

Bereits durch ein Prellen des Sicherheitsschalter (SI) würde dieser daher den parallelen Schalter (17) schließen. Bei Defekten der eigentlichen Auslöseschalter (dort T2,T3,T4) kommt es unmittelbar zur Auslösung.

Davon ausgehend liegt der Erfindung die Aufgabe zugrunde, einen noch sicheren Auslöseschaltkreis bereitzustellen.

Erfindungsgemäß wird diese Aufgabe bei einem Auslöseschaltkreis der eingangs genannten Art durch die kennzeichnenden Merkmale des Anspruchs 1 gelöst.

Erfindungsgemäß ist also im Auslöseschaltkreis eine Ansteuerschaltung vorgesehen, die einen in Reihe mit der Auslöseeinrichtung liegenden steuerbaren Schalter beim ersten Schließen des mechanischen Sicherheitsschalters schließt, also in seinen leitenden Zustand steuert, und die dann den steuerbaren Schalter infolge des Auslösestroms und/oder mittels eines retriggerbaren Zeitgliedes zumindest für eine vorbestimmte Zeit leitend hält. Durch diesen selbsthaltenden Charakter des von der Ansteuerschaltung beaufschlagten steuerbaren Schalters wird erreicht, daß über diesen der Auslösestrom unabhängig vom nachfolgenden Schaltzustand des mechanischen Sicherheitsschalters ungehindert fließen kann.

Öffnet also beispielsweise der mechanische Sicherheitsschalter infolge von Prellen nach dem ersten beschleunigungsbedingten Schließen, so ist dies für die Versorgung der Auslöseeinrichtung ohne Bedeutung, da der Auslösestrom über den ansteuerbaren Schalter ungehindert fließen kann.

Die in der Ansteuerschaltung vorgesehene Erkennungsschaltung erfaßt jedoch nicht nur den Zustand des mechanischen Sicherheitsschalters sondern auch den Zustand eines vom Steuergerät betätigten Schalters im Auslöseschaltkreis. Auf diese Weise läßt erhöht sich die Zuverlässigkeit des erfindungsgemäßen Auslöseschaltkreises, da der steuerbare Schalter im Auslösestromweg nur geschlossen wird, wenn der mechanische Sicherheitsschalter und ein vom Steuergerät beaufschlagter Schalter im Auslösestromweg geschlossen sind.

Die erfindungsgemäße Ausbildung des Auslöseschaltkreises hat insbesondere den Vorteil, daß auch relativ einfache und damit kostengünstige Schalter als mechanische Sicherheitsschalter eingesetzt werden können, ohne daß dadurch die Zuverlässigkeit des sicherheitskritischen Systems bzw. des Auslöseschaltkreises beeinträchtigt wird.

In besonders einfacher Weise läßt sich die Erkennungsschaltung zur Erkennung der Schalterzustände und des über die Auslöseeinrichtung fließenden Auslösestroms als Spannungsteiler realisieren, an dessen Mittelabgriff ein einem Ausgangskreis der Ansteuerschaltung zuzuführendes Feststellsignal abgenommen werden kann.

Ein besonders einfacher Schaltungsaufbau ergibt sich, wenn der Sicherheitsschalter und der steuerbare Schalter parallel zu einander geschaltet sind und mit der Auslöseeinrichtung in Reihe liegen. Diese Schaltung hat den Vorteil, daß der Auslösestrom sowohl über den mechanischen Sicherheitsschalter als auch über den dazu parallel liegenden steuerbaren Schalter fließt, sobald der mechanische Sicherheitsschalter nach einem eventuell auftretenden Prellen geschlossen bleibt. Hierdurch wird die Belastung des steuerbaren Schalters erheblich verringert. Demzufolge kann auch für den steuerbaren Schalter ein einfacherer und damit kostengünstigerer Schalter verwendet werden, da der steuerbare Schalter nur kurzfristig den gesamten Auslösestrom führen muß.

Eine weitere Vereinfachung des mechanischen Sicherheitsschalters wird möglich, wenn dieser parallel zur Auslöseeinrichtung liegt.

Die Erfindung wird im folgenden beispielsweise anhand der Zeichnung näher erläutert. Es zeigen:
- Fig. 1: ein schematisches Schaltbild eines erfindungsgemäßen Auslöseschaltkreises,
- Fig. 2: ein schematisches Blockschaltbild eines zweiten Ausführungsbeispiels eines erfindungsgemäßen Auslöseschaltkreises und
- Fig. 3: ein schematisches Blockschaltbild eines dritten Ausführungsbeispiels eines erfindungsgemäßen Auslöseschaltkreises mit einem retriggerbaren Zeitglied.

In den verschiedenen Figuren der Zeichnung sind einander entsprechende Bauteile und Schaltungselemente mit gleichen Bezugszeichen versehen.

Wie Figur 1 zeigt, ist der erfindungsgemäße Auslöseschaltkreis mit einem Eingangsanschluß 10 an einen Ausgang 11 einer nicht näher dargestellten Spannungsversorgungsquelle, z.B. eines Netzteils, und an einen Anschluß eines Speicherkondensators 12 angeschlossen, dessen anderer Anschluß an Masse liegt.

Ein mechanischer Sicherheitsschalter 13, ein erster von einem Mikroprozessor eines nicht dargestellten Steuergeräts beaufschlagbarer Schalter 14, eine Auslöseeinrichtung 15, z. B. eine Zündpille eines Airbags oder Gurtstraffersystems, und ein zweiter vom Mikroprozessor beaufschlagbarer Schalter 16 sind in dieser Reihenfolge in Reihe zwischen den Eingangsanschluß 10 und Masse geschaltet. Parallel zum mechanischen Sicherheitsschalter 13 liegt ein steuerbarer Schalter 17, z. B. ein Feldeffekttransistor, insbesondere ein MOS-Feldeffekttransistor, vorzugsweise ein selbstsperrender MOS-Feldeffekttransistor, der dessen Steuereingang über eine Leitung 18 von einer Ansteuerschaltung 19 mit einem Ansteuersignal beaufschlagbar ist, um den steuerbaren Schalter 17 in seinen leitenden Zustand zu steuern.

Die Ansteuerschaltung 19 umfaßt eine Erkennungsschaltung 20 und einen Ausgangskreis 21. Die Erkennungsschaltung 20 wird im dargestellten Ausführungsbeispiel von einer parallel zur Auslöseeinrichtung 15 geschalteten Reihenschaltung aus einer Diode 22 und zwei Widerständen 23, 24 gebildet. Die beiden Widerstände 23, 24 bilden einen Spannungsteiler 25, an dessen Mittelabgriff 26 ein Feststellsignal, das einen Auslösestrom anzeigt, abgenommen und an die Basis eines als Schalter wirkenden Transistors 27 des Ausgangskreises angelegt wird.

Der Transistor 27 ist mit einem Anschluß seiner Kollektor-Emitter-Strecke direkt an die Leitung 18, die den Steueranschluß des steuerbaren Schalters 17 darstellt, und über einen Widerstand 28 mit dem Eingangsanschluß 10 des Auslöseschaltkreises verbunden. Der andere Anschluß der Kollektor-Emitter-Strecke des Transistors 27 ist mit dem masseseitigen Anschluß der Auslöseeinrichtung 15 verbunden, so daß er über den Schalter 16 mit Masse verbindbar ist.

Wird beim Betrieb des erfindungsgemäßen Auslöseschaltkreises zusammen mit einem Steuergerät eines Insassenschutzsystems, z.B. eines Airbag-Systems, vom Steuergerät ein gefährlicher Aufprall erkannt, so werden die Schalter 14, 16, die die Auslöseeinrichtung 15 normalerweise auf einem schwebenden Potential halten, geschlossen, was durch die Pfeile µP angedeutet ist. Da bei einem gefährlichen Aufprall auch auf den mechanischen Sicherheitsschalter 13 erhebliche Beschleunigungskräfte wirken, wie durch den Pfeil a angedeutet ist, schließt dieser, so daß vom Eingangsanschluß 10 über den Sicherheitsschalter 13, den Schalter 14, die Auslöseeinrichtung 15 und den Schalter 16 ein Auslösestrom fließt.

Die infolge des Auslösestroms über der Auslöseeinrichtung 15 abfallende Spannung liegt dabei am Spannungsteiler 25 an, so daß am Mittelabgriff 26 eine zur Basis des Transistors 27 als Feststellsignal geführte Spannung auftritt, die die Kollektor-Emitter-Strecke des Transistors 27 in ihren leitenden Zustand bringt. Hierdurch wird die mittels der Leitung 18 an den Steueranschluß des steuerbaren Schalters 17 angelegte Spannung auf einen Wert gezogen, der den steuerbaren Schalter 17 in seinen leitenden Zustand bringt.

Je nach Auslegung des steuerbaren Schalters 17 bzw. des dafür verwendeten Feldeffekttransistors kann der Transistor 27 als reiner Schalter oder auch als widerstandsbehafteter Schalter betrieben werden, wobei im letzteren Falle der Widerstand 28 und die Kollektor-Emitter-Strecke des Transistors 27 einen Spannungsteiler bilden, der so ausgelegt ist, daß dem steuerbaren Schalter 17 die erforderliche Steuerspannung zugeführt wird.

Nachdem der steuerbare Schalter 17 in seinen leitenden Zustand gebracht ist, fließt der Auslösestrom ganz oder teilweise über den steuerbaren Schalter 17 zur Auslöseeinrichtung 15 je nachdem, ob der mechanische Sicherheitsschalter 13 geschlossen oder infolge von Prellen kurzzeitig geöffnet ist.

Da auf diese Weise der Auslösestrom nach dem ersten Schließen des mechanischen Sicherheitsschalters 13 ungehindert fließen kann, wird der steuerbare Schalter 17 auch ständig von der Ansteuerschaltung 19 in seinem leitenden Zustand gehalten.

Durch diese Selbsthaltung der Schaltung aus steuerbarem Schalter 17 und Ansteuerschaltung 19, also dadurch, daß der steuerbare Schalter 17 so lange leitend gehalten wird, wie ein Auslösestrom über ihn fließt, bleibt der erfindungsgemäße Auslöseschaltkreis unabhängig vom mechanischen Sicherheitsschalter 13 für den Auslösestrom leitend, selbst wenn der mechanische Sicherheitsschalter 13 infolge von Prellen kurzzeitig öffnen sollte.

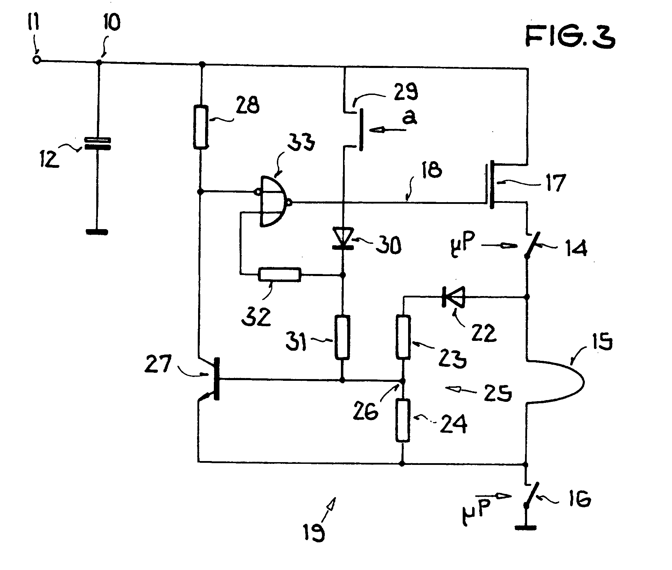

Fig. 2 zeigt einen weiteren erfindungsgemäßen Auslöseschaltkreis, bei dem die Auslöseeinrichtung 15 zusammen mit zwei Schaltern 14, 16 in Reihe zwischen einem Eingangsanschluß 10 und Masse liegt. Dabei ist zwischen dem in Bezug auf die Auslöseeinrichtung 15 eingangsseitigen Schalter 14 und dem Eingangsanschluß ein steuerbarer Schalter 17 angeordnet, dessen Steueranschluß über die Leitung 18 mit dem Ausgangskreis 21 der Ansteuerschaltung 19 verbunden ist.

Ein mechanischer Sicherheitsschalter 29 ist mit einer Diode 30 und einem Widerstand 31 zwischen den Eingangsanschluß 10 und den Mittelabgriff 26 des in der Erkennungsschaltung 20 vorgesehenen Spannungsteilers 25 in Reihe geschaltet.

Werden bei diesem Ansteuerschaltkreis die die Auslöseeinrichtung 15 auf schwebendem Potential haltenden Schalter 14, 16 von einem Steuergerät in ihren leitenden Zustand gebracht, wie durch die Pfeile µP angedeutet, und schließt der mechanische Sicherheitsschalter 29 infolge einer auf ihn wirkenden Beschleunigung, wie durch den Pfeil a angedeutet, so fließt zunächst vom Eingangsanschluß 10 über den mechanischen Sicherheitsschalter 29, die Diode 30, den Widerstand 31, den Widerstand 24 des Spannungsteilers 25 und den geschlossenen Schalter 16 ein Strom, der am Mittelabgriff 26 eines weiteren, aus Widerstand 31 und Widerstand 24 bestehenden Spannungsteilers eine Spannung bewirkt, die als Feststellsignal zur Basis des Transistors 27 geführt wird.

Infolge dessen wird, wie beim Ausführungsbeispiel nach Figur 1, vom Ausgangskreis 21 der Ansteuerschaltung 19 über die Leitung 18 ein den steuerbaren Schalter 17 in seinen leitenden Zustand bringendes Ausgangssignal an dessen Steuereingang angelegt.

Nachdem der steuerbare Schalter 17 im leitenden Zustand ist, kann ein Auslösestrom über die Auslöseeinrichtung 19 fließen, der mittels des Spannungsteilers 25 erfaßt wird und durch den, wie beim Ausführungsbeispiel nach Figur 1, der steuerbare Schalter 17 in seinem leitenden Zustand gehalten wird.

Auch bei dieser Ausgestaltung der Erfindung wird also der im Auslösestromweg angeordnete steuerbare Schalter 17 so lange leitend gehalten, wie ein Auslösestrom fließt.

Fig. 3 zeigt einen dritten Auslöseschaltkreis, der weitgehend dem anhand von Fig. 2 erläuterten Auslöseschaltkreis entspricht. Zusätzlich zu den Schaltungselementen des in Fig. 2 gezeigten Auslöseschaltkreises weist der dritte Auslöseschaltkreis ein retriggerbares Zeitglied 32 auf, dessen Eingangsanschluß mit dem Verbindungspunkt zwischen der Diode 30 und dem Widerstand 31 verbunden ist und dessen Ausgang an einen Eingang eines NOR-Gliedes 33 angelegt ist. Der Ausgang des NOR-Gliedes 33 ist mit der als Steueranschluß des steuerbaren Schalters 17 dienenden Leitung 18 verbunden. Der Anschluß der Kollektor-Emitter-Strecke des Transistors 27, der über den Widerstand 28 an den Eingangsanschluß 10 des Auslöseschaltkreises angeschlossen ist, ist an den anderen Eingang des NOR-Gliedes 33, der negiert ist, angeschlossen.

Das in der Fig. 3 dargestellte Zeitglied 32 ist so ausgelegt, das es einen anliegenden positiven Eingangsimpuls weiterleitet und von der negativen Flanke eines Eingangsimpulses so angesteuert wird, daß sein Ausgang nach einem Abfallen des Eingangsimpulses für eine vorbestimmte Zeit, z. B. 10 ms, auf einem dem positiven Eingangsimpuls entsprechenden positiven Pegel (logisch Eins) gehalten wird.

Im folgenden wird die Arbeitsweise des dritten Ansteuerschaltkreises beschrieben. Sobald der mechanische Sicherheitsschalter 29 bei leitenden Schaltern 14, 16 infolge einer auf ihn wirkenden Beschleunigung schließt, fließt vom Eingangsanschluß 10 über den mechanischen Sicherheitsschalter 29, die Diode 30, den Widerstand 31, den Widerstand 24 des Spannungsteilers 25 und den geschlossenen Schalter 16 ein Strom, der am Mittelabgriff 26 des aus Widerstand 31 und Widerstand 24 bestehenden Spannungsteilers eine Spannung bewirkt, die als Feststellsignal zur Basis des Transistors 27 geführt wird, so daß dieser leitet. Damit liegt am negierten Eingang des NOR-Gliedes 33 ein Massesignal als logisches Null-Signal an.

Gleichzeitig wird dem Eingang des Zeitgliedes 32 eine positive Spannung vom Verbindungspunkt zwischen Diode 30 und Widerstand 31 zu geführt, die als logische Eins am anderen Eingang des NOR-Gliedes 33 ansteht. Aufgrund jedes der beiden Eingangssignale steht am Ausgang des NOR-Gliedes 33 ein logisches Null-Signal an, das den steuerbaren Schlater 17, der beispielsweise als p-Kanal Feldeffekttransistor ausgelegt ist, in seinen leitenden Zustand steuert.

Unabhängig von der Zeitdauer des ersten Schließens des mechanischen Sicherheitsschalters 29 wird somit der steuerbare Schalter 17 zumindest für die vom Zeitglied 32 vorgegebene Zeit in seinen leitenden Zustand gesteuert.

Selbst wenn also der mechanische Sicherheitsschalter 29 nur so kurzfristig schließt, daß die vom Spannungsimpuls am Mittelabgriff 26 des Spannungsteilers aus Widerstand 31 und Widerstand 24 abgeleitete, am negierten Eingang des NOR-Gliedes 33 anliegende logische Null nicht lange genug anliegen würde, um den steuerbaren Schalter 17 in seinen leitenden Zustand zu steuern, wird mittels des Zeitgliedes 32 erreicht, daß der steuerbare Schalter 17 sicher in seinen leitenden Zustand gebracht wird, so daß ein Auslösestrom fließen kann.

Nachdem der steuerbare Schalter 17 im leitenden Zustand ist und ein Auslösestrom fließt, wird der steuerbare Schalter 17 aufgrund des Auslösestroms in seinem leitenden Zustand gehalten.

Bei dieser Ausgestaltung der Erfindung wird also der im Auslösestromweg angeordnete steuerbare Schalter 17 so lange leitend gehalten, wie der Ausgang des Zeitgliedes im hoch Zustand ist und/oder ein Auslösestrom über die Auslöseeinrichtung 19 fließt.

Das anhand von Fig. 3 beschriebene retriggerbare Zeitglied 32 läßt sich auch in entsprechender Weise bei einem Auslöseschaltkreis einsetzen, wie er anhand von Fig. 1 beschrieben wurde. Hierbei wäre dann der Eingang des Zeitgliedes 32 mit dem Verbindungspunkt zwischen der Diode 22 und dem Widerstand 23 des Spannungsteilers 25 zu verbinden.

Ferner ist es auch möglich, den steuerbaren Schalter 17 unabhängig vom Auslösestrom nur mit dem retriggerbaren Zeitglied 32, das den Strom über den mechanischen Sicherheitsschalter erfaßt, in seinen leitenden Zustand zu steuern und darin zu halten.

Die vorliegende Erfindung ermöglicht es unabhängig vom Prellverhalten mechanischer Schalter, einen mechanischen Schalter entweder als Sicherheitsschalter in Reihe (Figur 1) oder als Triggerschalter parallel (Figur 2 und 3) zur Auslöseeinrichtung 15 vorzusehen. Mechanische Sicherheitsschalter lassen sich also erfindungsgemäß direkt im Auslöseschaltkreis anordnen, wodurch eine zuverlässige mechanische Überwachung des Steuergerätes ermöglicht wird und eine Fehlauslösung infolge eines fehlerhaften Mikroprozessors im Steuergerät oder Beschleunigungsaufnehmers sicher ausgeschlossen werden kann.

Ein weiterer Vorteil dieser Erfindung besteht darin, daß entweder - wie in Figur 1 gezeigt - die Parallelschaltung von mechanischem Sicherheitsschalter 13 und steuerbarem Schalter 17 oder - wie in Figur 2 gezeigt - der steuerbare Schalter 17 allein die Funktion des in Bezug auf die Auslöseeinrichtung 15 eingangsseitigen Schalters 14 übernehmen kann. Somit wird der in Bezug auf die Auslöseeinrichtung 15 eingangsseitige Schalter 14 überflüssig und kann weggelassen werden, ohne daß die potentialfreie Anordnung der Auslöseeinrichtung beeinträchtigt wird.

## Patentansprüche

1. Auslöseschaltkreis, insbesondere für sicherheitskritische Insassenschutzsysteme für Fahrzeuge zur Personenbeförderung,
a) mit einer Auslöseeinrichtung (15) für ein eine Person im Falle eines gefährlichen Aufpralls schützendes Mittel, wobei die Auslöseeinrichtung in Reihe mit wenigstens einem ersten Schalter (16,14) geschaltet ist, über den sie zur Betätigung des eine Person schützenden Mittels mit einem Auslösestrom beaufschlagbar ist, und
b) mit einem auf Beschleunigungen ansprechenden mechanischen Sicherheitsschalter (13), der beim Auftreten einer im Falle eines gefährlichen Aufpralls wirkenden Beschleunigung den Auslösestromweg freigibt,
c) wobei eine Ansteuerschaltung (19) vorgesehen ist, deren Ausgangssignal einen weiteren im Auslösestromweg angeordneten steuerbaren Schalter (17) in Abhängigkeit von den Schaltzuständen des Sicherheitsschalters (13; 29) in seinen leitenden Zustand steuert und den leitenden steuerbaren Schalter (17) im leitenden Zustand hält,
**dadurch gekennzeichnet, daß**
d) die Ansteuerschaltung (19) neben dem Schaltzustand des Sicherheitsschalters (13; 29) auch den Schaltzustand des ersten in Reihe liegenden Schalters (16, 14) erfaßt und nur in Abhängigkeit beider den weiteren leitenden steuerbaren Schalter (17) aktiviert.

2. Auslöseschaltkreis nach Anspruch 1, dadurch **gekennzeichnet,** daß die Ansteuerschaltung (19) den leitenden steuerbaren Schalter (17) in Abhängigkeit vom Auslösestrom oder für eine mittels eines Zeitgliedes vorbestimme Zeit im leitenden Zustand hält.

3. Auslöseschaltkreis nach Anspruch 1 oder 2, dadurch **gekennzeichnet,** daß die Ansteuerschaltung (19) zur Feststellung der Schalterzustände und des Auslösestroms eine Erkennungschaltung (20) umfaßt, die ein Festellsignal einem das Ausgangssignal der Ansteuerschaltung erzeugenden Ausgangskreis (21) zuführt.

4. Auslöseschaltkreis nach Anspruch 3, dadurch **gekennzeichnet,** daß die Erkennungsschaltung (20) zur Erkennung des Schaltzustands des Sicherheitsschalters (13; 29) einen Spannungsteiler (25; 24, 31) umfaßt, der mit dem Sicherheitsschalter und dem zumindest einen mit der Auslöseeinrichtung (15) in Reihe liegenden Schalter (16, 14) in Reihe geschaltet ist.

5. Auslöseschaltkreis nach Anspruch 3 oder 4, dadurch **gekennzeichnet,** daß die Erkennungsschaltung (20) zur Feststellung des Auslösestroms die über der Auslöseeinrichtung (15) abfallende Spannung erfaßt.

6. Auslöseschaltkreis nach Anspruch 5, dadurch **gekennzeichnet,** daß die Erkennungsschaltung (20) zur Erfassung der an der Auslöseeinrichtung (15) abfallenden Spannung einen dazu parallel geschalteten Spannungsteiler (25) umfaßt.

7. Auslöseschaltkreis nach Anspruch 6, dadurch **gekennzeichnet,** daß der zur Auslöseeinrichtung (15) parallel geschaltete Spannungsteiler (25) zur Feststellung des Auslösestroms und der Schalterzustände vorgesehen ist.

8. Auslöseschaltkreis nach einem der Ansprüche 1 bis 7, dadurch **gekennzeichnet**, daß der Sicherheitsschalter (13) und der steuerbare Schalter (17) parallel zueinander geschaltet sind und mit der Auslöseeinrichtung (15) in Reihe liegen.

9. Auslöseschaltkreis nach einem der Ansprüche 1 bis 6, dadurch **gekennzeichnet,** daß der Sicherheitsschalter (29) parallel zur Auslöseeinrichtung (15) liegt.

10. Auslöseschaltkreis nach einem der Ansprüche 1 bis 9, dadurch **gekennzeichnet,** daß der steuerbare Schalter (17) ein Feldeffekttransistor ist.

11. Auslöseschaltkreis nach Anspruch 10, dadurch **gekennzeichnet,** daß der Feldeffekttransistor ein MOS-Feldeffekttransistor, vorzugsweise ein selbstsperrender MOS-Feldeffekttransistor ist.

## Claims

1. Trigger circuit, in particular for safety-critical passenger protection systems for vehicles for passenger transport,
a) with a trigger device (15) for a means which protects a passenger in the case of a dangerous impact, wherein the trigger device is connected in series with at least one first switch (16, 14), by means of which it can receive a trigger current to actuate the means protecting a passenger, and
b) with a mechanical safety switch (13) which responds to accelerations and which enables the flow of trigger current upon the occurrence of an acceleration effective in the case of a dangerous impact,
c) wherein a control circuit (19) is provided, the output signal of which controls a further controllable switch (17), which is disposed in the trigger current path, into its conductive state in accordance with the switched states of the safety switch (13; 29) and maintains the conductive controllable switch (17) in the conductive state,
**characterised in that,**
d) in addition to the switched state of the safety switch (13; 29), the control circuit (19) also senses the switched state of the first switch (16, 14) lying in series and only activates the further conductive controllable switch (17) in accordance with both states.

2. Trigger circuit according to Claim 1, characterised in that the control circuit (19) maintains the conductive controllable switch (17) in the conductive state in accordance with the trigger current or for a time which is predetermined by means of a timing element.

3. Trigger circuit according to Claim 1 or 2, characterised in that the control circuit (19) comprises a recognition circuit (20) to detect the switch states and the trigger current, which circuit supplies a detection signal to an output circuit (21) which generates the output signal of the control circuit.

4. Trigger circuit according to Claim 3, characterised in that the recognition circuit (20) comprises a voltage divider (25; 24, 31) to recognise the switched state of the safety switch (13; 29), which divider is connected in series with the safety switch and the at least one switch (16, 14) lying in series with the trigger device (15).

5. Trigger circuit according to Claim 3 or 4, characterised in that the recognition circuit (20) senses the voltage dropping across the trigger device (15) in order to detect the trigger current.

6. Trigger circuit according to Claim 5, characterised in that the recognition circuit (20) comprises a voltage divider (25) connected in parallel with the trigger device (15) in order to sense the voltage dropping at the latter.

7. Trigger circuit according to Claim 6, characterised in that the voltage divider (25) connected in parallel with the trigger device (15) is provided to detect the trigger current and the switch states.

8. Trigger circuit according to any one of Claims 1 to 7, characterised in that the safety switch (13) and the controllable switch (17) are connected in parallel with one another and lie in series with the trigger device (15).

9. Trigger circuit according to any one of Claims 1 to 6, characterised in that the safety switch (29) lies in parallel with the trigger device (15).

10. Trigger circuit according to any one of Claims 1 to 9, characterised in that the controllable switch (17) is a field-effect transistor.

11. Trigger circuit according to Claim 10, characterised in that the field-effect transistor is a MOS field-effect transistor, preferably a normally off MOS field-effect transistor.

## Revendications

1. Circuit de déclenchement notamment pour des systèmes, critiques du point de vue sécurité, de protection pour des passagers de véhicules pour le transport de personnes, comportant:
a) un dispositif de déclenchement (15) pour un moyen protégeant une personne dans le cas d'un choc dangereux, le dispositif de déclenchement étant branché en série avec au moins un premier interrupteur (16, 14), au moyen duquel le dispositif de déclenchement peut être chargé par un courant de déclenchement pour l'actionnement du moyen protégeant une personne, et
b) un interrupteur mécanique de sécurité (13), qui répond à des accélérations et qui libère le trajet du courant de déclenchement lors de l'apparition d'une accélération agissant dans le cas d'un choc dangereux,
c) dans lequel il est prévu un circuit de commande (19), dont le signal de sortie place dans son état conducteur un autre interrupteur commandable (17), qui est disposé dans le trajet du courant de déclenchement, en fonction des états de commutation de l'interrupteur de sécurité (13; 29), et maintient l'interrupteur commandable conducteur (17) dans son état conducteur,
caractérisé en ce que
d) le circuit de commande (19) détecte, en dehors de l'état de commutation de l'interrupteur de sécurité (13; 29), également l'état de commutation du premier interrupteur (16, 14) branché en série et active uniquement en fonction des deux états, l'autre interrupteur commandable conducteur (17).

2. Circuit de déclenchement selon la revendication 1, caractérisé en ce que le circuit de commande (19) maintient l'interrupteur commandable conducteur (17) à l'état conducteur en fonction du courant de déclenchement ou bien pendant un intervalle de temps prédéterminé au moyen d'un circuit de temporisation.

3. Circuit de déclenchement selon la revendication 1 ou 2, caractérisé en ce que le circuit de commande (19) comprend, pour la détermination des états des interrupteurs et du courant de déclenchement, un circuit d'identification (20) qui envoie un signal de détermination à un circuit de sortie (21) produisant le signal de sortie du circuit de commande.

4. Circuit de déclenchement selon la revendication 3, caractérisé en ce que le circuit d'identification (20) pour l'identification de l'état de commutation de l'interrupteur de sécurité (13; 29) comprend un diviseur de tension (25; 24; 31), qui est branché en série avec l'interrupteur de sécurité et le ou moins un interrupteur (16, 14) disposé en série avec le dispositif de déclenchement (15).

5. Circuit de déclenchement selon la revendication 3 ou 4, caractérisé en ce que le circuit d'identification (20) servant à déterminer le courant de déclenchement détecte la tension qui chute dans le dispositif de déclenchement (15).

6. Circuit de déclenchement selon la revendication 5, caractérisé en ce que le circuit d'identification (20) servant à détecter la tension qui chute dans le dispositif de déclenchement (15) comprend un diviseur de tension (25) branché en parallèle avec ce dispositif.

7. Circuit de déclenchement selon la revendication 6, caractérisé en ce que le diviseur de tension (25) branché en parallèle avec le dispositif de déclenchement (15) est prévu pour déterminer le courant de déclenchement et les états des interrupteurs.

8. Circuit de déclenchement selon l'une des revendication 1 à 7, caractérisé en ce que l'interrupteur de sécurité (13) et l'interrupteur commandable (17) sont branchés en parallèle entre eux et sont disposés en série avec le dispositif de déclenchement (15).

9. Circuit de déclenchement selon l'une des revendications 1 à 6, caractérisé en ce que l'interrupteur de sécurité (29) est branché en parallèle avec le dispositif de déclenchement (15).

10. Circuit de déclenchement selon l'une des revendications 1 à 9, caractérisé en ce que l'interrupteur commandable (17) est un transistor à effet de champ.

11. Circuit de déclenchement selon la revendication 10, caractérisé en ce que le transistor à effet de champ est un transistor à effet de champ MOS, de préférence un transistor à effet de champ MOS auto-bloquant.
